# EUROPEAN PATENT APPLICATION

(11) **EP 3 730 530 A1**
(43) Date of publication of application: **28.10.2020**
(21) Application number: 18901637.1
(22) Date of filing: 27.12.2018
(51) Int. Cl.: C08G 59/00, C08L 63/00, C08L 101/00, H01L 21/54, H01L 23/24, H01L 23/28

(54) **CURABLE RESIN COMPOSITION, SEMICONDUCTOR DEVICE, AND METHOD FOR PRODUCING SEMICONDUCTOR DEVICE**

(30) Priority: 16.01.2018 JP 2018005175
(71) Applicant: Hitachi Chemical Company, Ltd., Chiyoda-ku, Tokyo 100-6606 (JP)
(72) Inventor: MURASUGI, Narutoshi, Tokyo 100-6606 (JP); ARATA, Michitoshi, Tokyo 100-6606 (JP); TOGAWA, Mitsuo, Tokyo 100-6606 (JP); ONO, Yuta, Tokyo 100-6606 (JP)
(74) Representative: Hoffmann Eitle
(86) International application number: PCT/JP2018/048293
(87) International publication number: WO 2019/142646

(57) **Abstract**

A curable resin composition for non-pressurized type case mold sealing, which is solid at 25°C and which has a gelation time at 110°C of 10 min or more.

## Description

### Technical Field

The present invention relates to a curable resin composition, a device, and a method of producing semiconductor device.

### Background Art

As for an electronic apparatus, corresponding to the recent trend of miniaturization and higher functionality, the packaging density is increasing, and further the amount of heat generation is increasing due to higher power output. In response to this, a curable resin composition, which is used for the purpose of protecting a module including a chip, an insulation substrate, a copper base plate, a solder, a wire or the like from the external environment, is required to have heat resistance in consideration of use in an electronic apparatus.

An example of the modules that are required to be used under high temperature for a long duration due to a large amount of heat generation is a power module for an automobile, railway or the like. Since a high voltage is applied to the power module, the amount of heat generation of a chip is remarkably large, guaranteed performances of the same as well as constituent elements under high temperature are essential.

Examples of a method for sealing a power module include a method by which sealing is achieved by pouring silicone gel into a case mold open to the atmosphere (hereinafter also referred to as "case mold gel sealing method") (see, for example, Patent Literature 1). Since silicone gel is liquid at 25°C (room temperature), it is not necessary to form a hermetically closed state in a mold as in other cases such as a transfer sealing method or a compression sealing method, and filling may be advantageously performed easily and uniformly for an open case by the own weight.

### Prior Art Document

### Patent Documents

Patent Document 1: Japanese Patent Application Laid-Open (JP-A) No. 2014-216558

### SUMMARY OF INVENTION

### Technical Problem

However, in the case of the case mold gel sealing method, there is a large difference in the coefficient of thermal expansion between the constituent elements of a power module and the silicone gel covering the whole, and therefore the reliability at high temperatures is poor. Further, there is a drawback in that heat generated from the chip causes a contact fault due to siloxane.

The present invention has been made in view of such a situation with an object to provide a curable resin composition that is capable of performing non-pressurized type case mold sealing, and is excellent in heat resistance and high temperature stability, when it is cured; a semiconductor device sealed with the curable resin composition; and a method of producing the semiconductor device using the curable resin composition.

### Means for Solving the Problems

A specific means for solving the above-described problems includes the following embodiments.
<1> A curable resin composition for non-pressurized type case mold sealing, which is solid at 25°C and which has a gelation time at 110°C of 10 min or more.
<2> The curable resin composition for non-pressurized type case mold sealing according to claim 1, in which the curable resin composition has a viscosity at 110°C of 1000 Pa·s or less.
<3> The curable resin composition for non-pressurized type case mold sealing according to <1> or <2>, in which the curable resin composition has a gelation time at 175°C of 2 hours or less.
<4> The curable resin composition for non-pressurized type case mold sealing according to any one of <1> to <3>, in which a ratio of a glass transition temperature (Tg) after an elapse of 1000 hours at 215°C and that before the lapse of time (Tg after the lapse of time/Tg at initial stage) is 0.9 or more in a case in which the curable resin composition is cured.
<5> The curable resin composition for non-pressurized type case mold sealing according to any one of <1> to <4>, in which an average coefficient of thermal expansion in a range of from 30°C to 250°C, is 50 ppm/K or less in a case in which the curable resin composition is cured.
<6> The curable resin composition for non-pressurized type case mold sealing according to any one of <1> to <5>, in which a modulus of elasticity at 25°C is from 5 GPa to 25 GPa in a case in which the curable resin composition is cured.
<7> A semiconductor device including:
   a semiconductor element, and
   a cured product of the curable resin composition according to any one of <1> to <6>, which seals the semiconductor element.
<8> A method of producing a semiconductor device including:
   accommodating a semiconductor element in a non-pressurized type case,
   filling the non-pressurized type case with the curable resin composition according to any one of <1> to <7> by putting the curable resin composition in a solid state into the non-pressurized type case and then heating to melt the curable resin composition, or heating to melt the curable resin composition and then pouring the curable resin composition into the non-pressurized type case, and
   curing the curable resin composition in the non-pressurized type case.

### Advantageous Effects of Invention

According to the present invention, a curable resin composition which is capable performing non-pressurized type case mold sealing, and which is excellent in heat resistance and high temperature stability, when it is cured; a semiconductor device sealed with the curable resin composition; and a method of producing the semiconductor device using the curable resin composition can be provided.

### DESCRIPTION OF EMBODIMENTS

In the present disclosures, each numerical range specified using "(from) ... to ..." represents a range including the numerical values noted before and after "to" as the minimum value and the maximum value, respectively.

In the present disclosures, with respect to numerical ranges stated hierarchically herein, the upper limit or the lower limit of a numerical range of a hierarchical level may be replaced with the upper limit or the lower limit of a numerical range of another hierarchical level. Further, in the present disclosures, with respect to a numerical range, the upper limit or the lower limit of the numerical range may be replaced with a relevant value shown in any of Examples.

In the present disclosures, each component may include plural kinds of substances corresponding to the component. In a case in which plural kinds of substances exist corresponding to a component in the composition, the content means, unless otherwise specified, the total amount of the plural kinds of substances existing in the composition.

In the present disclosures, each component may include plural kinds of particles corresponding to the component. In a case in which plural kinds of particles exist corresponding to a component in the composition, the particle diameter means, unless otherwise specified, a value with respect to the mixture of the plural kinds of particles existing in the composition.

In the present disclosures, the term "process" denotes not only independent processes but also processes that cannot be clearly distinguished from other processes as long as a purpose is accomplished by the process.

### < Curable Resin Composition >

The v resin composition in the present disclosures is used for non-pressurized type case mold sealing, which is solid at 25°C and which has a gelation time at 110°C of 10 min or more. The resin curable composition in the present disclosures may further contain another component, if necessary.

In the present disclosures, "non-pressurized type case mold sealing" means a sealing method in which a curable resin composition is uniformly poured into a case or mold not by application of a pressure in a closed state, but rather by the own weight of the curable resin composition. "Pressurized type case mold sealing" means a sealing method in which a closed space formed by the case or the mold is completely filled with a curable resin composition by application of a pressure so as to suppress uneven distribution of the curable resin composition in the case or the mold.

For example, when a case has an upper lid, it is surrounded by walls on all sides. However, when there remains a space, for example, at the upper part inside the case before the case is fully filled with a curable resin composition after introduction of the same, the curable resin composition is not pressurized, and therefore this is regarded as non-pressurized type case mold sealing.

On the other hand, in a method in which a mold closed on all sides excluding an inlet is fully filled with a curable resin composition such as in transfer sealing, in a method in which a curable resin composition in a case is pressed with an upper lid to fill the case such as in compression sealing, or in a similar method, the curable resin composition is pressurized at the completion of the filling, and therefore, this is regarded as pressurized type case mold sealing.

After the filling, the pressurization may be continued or discontinued.

Therefore, it is conceivable that a curable resin composition, which is conventionally used for transfer sealing, compression sealing, or the like, and is solid at 25°C, may be applied to non-pressurized type case mold sealing. A curable resin composition, which is solid at 25°C, is superior in heat resistance owing to its molecular structure. However, since the conventional curable resin composition, which is solid at 25°C, is designed to be packed into a tightly closed mold by applying a pressure, by simple application of the composition to non-pressurized type case mold sealing, the case mold cannot be even filled, and sealing is obviously impossible.

Based on these considerations, a curable resin composition in the present disclosures is solid at 25°C and has a gelation time at 110°C of 10 min or more. When the gelation time at 110°C is 10 min or more, it is possible to secure a sufficient time until gelation takes place, so that its packing property can be excellent even when it is applied to non-pressurized type case mold sealing.

Each component of a curable resin composition will be described below, provided that the curable resin composition in the present disclosures is not limited thereto.

### (Curable Resin)

There is no particular restriction on a curable resin to be included in a curable resin composition. Examples of the curable resin include an epoxy resin, a phenol resin, a bismaleimide resin, a cyanate resin, a polyamide resin, and a polyimide resin. From the viewpoint of the balance of various properties as a sealing material, an epoxy resin is preferable.

There is no particular restriction on the kind of epoxy resin, and it can be selected according to the desired characteristics of a curable resin composition. Specific examples of the epoxy resin include a novolak epoxy resin (phenol novolak epoxy resin, ortho-cresol novolak epoxy resin, or the like.) which is an epoxidation product of a novolak resin which is a condensation product or co-condensation product of at least one phenolic compound selected from the group consisting of phenolic compounds such as phenol, cresol, xylenol, resorcinol, catechol, bisphenol A or bisphenol F, and naphthol compounds such as α-naphthol, β-naphthol or dihydroxynaphthalene, with an aliphatic aldehyde compound such as formaldehyde, acetaldehyde or propionaldehyde, in the presence of an acidic catalyst; a triphenylmethane epoxy resin which is an epoxidation product of a triphenylmethane phenol resin which is a condensation product or co-condensation product of the above phenolic compound with an aromatic aldehyde compound such as benzaldehyde or salicylaldehyde, in the presence of an acidic catalyst; a copolymer epoxy resin which is an epoxidation product of a novolak resin which is a co-condensation product of the above phenolic compound and naphthol compound with the aldehyde compound in the presence of an acidic catalyst; a diphenylmethane epoxy resin which is a diglycidyl ether of bisphenol A, bisphenol F or the like; a biphenyl epoxy resin which is a diglycidyl ether of an alkyl-substituted or unsubstituted biphenol; a stilbene epoxy resin which is a diglycidyl ether of a stilbene-based phenolic compound; a sulfur atom-containing epoxy resin which is a diglycidyl ether of bisphenol S; an epoxy resin which is a glycidyl ether of an alcohol such as butanediol, polyethylene glycol or polypropylene glycol; a glycidyl ester epoxy resin which is a glycidyl ester of a polyvalent carboxylic acid compound such as phthalic acid, isophthalic acid or tetrahydrophthalic acid; a glycidyl amine epoxy resin in which an active hydrogen bonded to a nitrogen atom in aniline, diaminodiphenylmethane, isocyanuric acid, or the like is substituted with a glycidyl group; a dicyclopentadiene epoxy resin which is an epoxidation product of a cocondensed resin of dicyclopentadiene and a phenolic compound; an alicyclic epoxy resin such as vinylcyclohexene diepoxide, 3,4-epoxycyclohexylmethyl-3,4-epoxycyclohexanecarboxylate, 2-(3,4-epoxy)cyclohexyl-5,5-spiro(3,4-epoxy)cyclohexane-*m*-dioxane or the like, in which an olefin bond in the molecule is epoxidized; a *par*a-xylylene-modified epoxy resin which is a glycidyl ether of a *par*a-xylylene-modified phenol resin; a meta-xylylene-modified epoxy resin which is a glycidyl ether of a *meta*-xylylene-modified phenol resin; a terpene-modified epoxy resin which is a glycidyl ether of a terpene-modified phenol resin; a dicyclopentadiene-modified epoxy resin which is a glycidyl ether of a dicyclopentadiene-modified phenol resin; a cyclopentadiene-modified epoxy resin which is a glycidyl ether of a cyclopentadiene-modified phenol resin; a polycyclic aromatic ring-modified epoxy resin which is a glycidyl ether of a polycyclic aromatic ring-modified phenol resin; a naphthalene epoxy resin which is a glycidyl ether of a naphthalene ring-containing phenol resin; a halogenated phenol novolak epoxy resin; a hydroquinone epoxy resin; a trimethylolpropane epoxy resin; a linear aliphatic epoxy resin obtained by oxidizing an olefin bond with peracid such as peracetic acid; an aralkyl epoxy resin which is epoxidation product of an aralkyl phenol resin such as a phenol aralkyl resin or a naphthol aralkyl resin. These epoxy resins may be used singly or in combination of two or more kinds thereof.

An epoxy equivalent (molecular weight/numbers of epoxy group) is not particularly limited. From the viewpoint of the balance between the various characteristics such as moldability and electrical reliability, the epoxy equivalent is preferably from 100 g/eq to 1000 g/eq, and more preferably from 150 g/eq to 500 g/eq.

The epoxy equivalent of the epoxy resin may be measured by a method according to JIS K 7236: 2009.

In a case in which the epoxy resin is solid, a melting point or softening point of the epoxy resin is not particularly limited. From the viewpoint of a resistance to thermal decomposition, it is preferably 50°C or more, and from the viewpoint of handling the curable resin composition during preparation, it is preferably from 50°C to 130°C.

The melting point of the epoxy resin may be measured by a differential scanning calorimetry (DSC), and the softening point of the epoxy resin may be measured by a method described in JIS K 7234: 1986 (ring-and-ball method).

### (Curing Agent)

There is no particular restriction on the kind of a curing agent, and it may be selected according to the desired characteristics of a curable resin composition. In a case in which a curable resin is an epoxy resin, examples of the curing agent include a phenolic curing agent, an aminic curing agent, an acid anhydridic curing agent, a polymercaptanic curing agent, a polyaminoamidic curing agent, an isocyanatic curing agent, and a blocked isocyanatic curing agent. From the viewpoint of heat resistance, the curing agent is preferably one having a phenolic hydroxy group in the molecule (phenolic curing agent).

Specific examples of the phenolic curing agent include a polyhydric phenolic compound such as resorcinol, catechol, bisphenol A, bisphenol F, or a substituted or unsubstituted biphenol; a novolak phenol resin which is a condensation product or co-condensation product of at least one phenolic compound selected from the group consisting of a phenolic compound such as phenol, cresol, xylenol, resorcinol, catechol, bisphenol A, bisphenol F, phenylphenol or aminophenol, and a naphtholic compound such as α-naphthol, β-naphthol, or dihydroxynaphthalene, with an aliphatic aldehyde compound such as formaldehyde, acetaldehyde or propionaldehyde in the presence of an acidic catalyst; an aralkyl phenol resin such as a phenol aralkyl resin or a naphthol aralkyl resin, which is synthesized from any of the above phenolic compounds, and dimethoxy-para-xylene, bis(methoxymethyl)biphenyl or the like; a phenol resin modified with at least one of para-xylylene and *meta*-xylylene; a melamine-modified phenol resin; a terpene-modified phenol resin; a dicyclopentadiene phenol resin and a dicyclopentadiene-type naphthol resin, which are synthesized by copolymerization of any of the above phenolic compounds and dicyclopentadiene; a cyclopentadiene-modified phenol resin; a polycyclic aromatic ring-modified phenol resin; a biphenyl phenol resin; and a triphenylmethane phenol resin which is a condensation product or co-condensation product of any of the above phenolic compounds with an aromatic aldehyde compound such as benzaldehyde or salicylaldehyde in the presence of an acidic catalyst; as well as a phenol resin obtained by copolymerization of two or more of these. These phenolic curing agents may be used singly or in combination of two or more kinds thereof.

A functional group equivalent of the curing agent (in a case in which the curing agent is phenolic curing agent, the functional group means a hydroxyl group) is not particularly limited. From the viewpoint of the balance between the various characteristics such as moldability and electrical reliability, it is preferably from 70 g/eq to 1000 g/eq, and more preferably from 80 g/eq to 500 g/eq.

The functional group equivalent of the curing agent (in a case in which the curing agent is phenolic curing agent, the functional group means a hydroxyl group) may be measured, for example, by a method according to JIS K 0070: 1992.

In a case in which the epoxy resin is solid, a melting point or softening point of the curing is not particularly limited. From the viewpoint of a resistance to thermal decomposition, it is preferably 40°C or more, from the viewpoint of moldability or the like, it is preferably from 40°C to 180°C, and from the viewpoint of handling the curable resin composition during preparation, it is preferably from 50°C to 130°C.

The melting point or softening point of the curing agent may be measured by the same manners as that of the epoxy resin.

An equivalent weight ratio of the curable resin to the curing agent, namely a ratio of the numbers of functional groups in the curing agent with respect to the numbers of functional groups in the curable resin (numbers of functional groups in the curing agent/ numbers of functional groups in the curable resin) is not particularly limited. In order to reduce nonreactive ones in each group, the ratio is set preferably in a range of from 0.5 to 2.0, and more preferably in a range of from 0.6 to 1.3. From the viewpoint of moldability, the ratio is set still more preferably in a range of from 0.8 to 1.2.

### (Filler)

A curable resin composition may contain a filler. In a case in which a curable resin composition contains a filler, the kind of filler is not particularly limited. Specific examples of a filler include an inorganic material such as silica (fused silica, crystalline silica or the like), glass, alumina, calcium carbonate, zirconium silicate, calcium silicate, silicon nitride, aluminum nitride, boron nitride, beryllia, zirconia, zircon, forsterite, steatite, spinel, mullite, titania, talc, clay, or mica. A filler having a flame retardant effect may be used. Examples of the filler having a flame retardant effect include aluminum hydroxide, magnesium hydroxide, a composite metal hydroxide such as a composite hydroxide of magnesium and zinc, and zinc borate.

Among the above fillers, silica is preferable from the viewpoint of reducing a coefficient of thermal expansion, and alumina is preferable from the viewpoint of high thermal conductivity. The fillers may be used singly or in combination of two or more kinds thereof. Examples of shape of a filler include a powder, a bead spheroidized from a powder, and a fiber.

A content of a filler in a curable resin composition is not particularly limited. From the viewpoint of fluidity and strength, the content of a filler is preferably from 30% by volume to 90% by volume with respect to the entire curable resin composition, more preferably from 35% by volume to 80% by volume, further preferably from 40% by volume to 70% by volume, and especially preferably from 50% by volume to 70% by volume. In a case in which the content of a filler is 30% by volume or more with respect to the entire curable resin composition, the characteristics of a cured product, such as coefficient of thermal expansion, thermal conductivity, or modulus of elasticity, tend to be improved. In a case in which the content of a filler is 90% by volume or less with respect to the entire curable resin composition, increase in the viscosity of the curable resin composition is suppressed to improve the fluidity, and the moldability tends to be improved.

In a case in which a shape of filler is particulate, its average particle diameter is not particularly limited. For example, the volume average particle diameter is preferably from 0.2 µm to 50 µm, and more preferably from 0.5 µm to 30 µm. In a case in which the volume average particle diameter is 0.2 µm or more, increase in the viscosity of the curable resin composition tends to be further suppressed. In a case in which the volume average particle diameter is 20 µm or less, the packing property into a narrow gap tends to be further improved.

The volume average particle diameter of a filler may be measured as a particle diameter (D50) at the point where the cumulative volume from the small diameter side reaches 50% in the volume-based particle size distribution measured with a laser scattering diffraction particle size distribution analyzer.

### (Curing Accelerator)

A curable resin composition may contain a curing accelerator. There is no particular restriction on the kind of curing accelerator, and it may be selected according to the kind of curable resin, desired characteristics of a curable resin composition, or the like.

Examples of a curing accelerator include a cyclic amidine compound such as a diazabicycloalkene including 1,5-diazabicyclo[4.3.0]nonene-5 (DBN), and 1,8-diazabicyclo[5.4.0]undecene-7 (DBU), 2-methylimidazole, 2-phenylimidazole, 2-phenyl-4-methylimidazole, or 2-heptadecylimidazole; a derivative of the cyclic amidine compound; a phenol novolak salt of the cyclic amidine compound, or a derivative thereof; a compound with intramolecular polarization obtained by adding, to any of the above compounds, a compound having a π bond, such as maleic anhydride, a quinone compound including 1,4-benzoquinone, 2,5-toluquinone, 1,4-naphthoquinone, 2,3-dimethylbenzoquinone, 2,6-dimethylbenzoquinone, 2,3-dimethoxy-5-methyl-1,4-benzoquinone, 2,3-dimethoxy-1,4-benzoquinone, and phenyl-1,4-benzoquinone, or diazophenylmethane; a cyclic amidinium compound such as a tetraphenylborate salt of DBU, a tetraphenylborate salt of DBN, a tetraphenylborate salt of 2-ethyl-4-methylimidazole, or a tetraphenylborate salt of *N*-methylmorpholine; a tertiary amine compound such as pyridine, triethylamine, triethylenediamine, benzyldimethylamine, triethanolamine, dimethylaminoethanol, or tris(dimethylaminomethyl)phenol; a derivative of the tertiary amine compound; an ammonium salt compound such as tetra-*n*-butylammonium acetate, tetra-*n*-butylammonium phosphate, tetraethylammonium acetate, tetra-*n*-hexylammonium benzoate, or tetrapropylammonium hydroxide; a tertiary phosphine such as triphenylphosphine, diphenyl(*p*-tolyl)phosphine, a tris(alkylphenyl)phosphine, a tris(alkoxyphenyl)phosphine, a tris(alkyl-alkoxyphenyl)phosphine, a tris(dialkylphenyl)phosphine, a tris(trialkylphenyl)phosphine, a tris(tetraalkylphenyl)phosphine, a tris(dialkoxyphenyl)phosphine, a tris(trialkoxyphenyl)phosphine, a tris(tetraalkoxyphenyl)phosphine, a trialkylphosphine, a dialkylarylphosphine, or an alkyldiarylphosphine; a phosphine compound such as a complex of the tertiary phosphine and an organic boron; a compound with intramolecular polarization obtained by adding any of the above tertiary phosphines or phosphine compounds, and a compound having a π bond, such as maleic anhydride, a quinone compound including 1,4-benzoquinone, 2,5-toluquinone, 1,4-naphthoquinone, 2,3-dimethylbenzoquinone, 2,6-dimethylbenzoquinone, 2,3-dimethoxy-5-methyl-1,4-benzoquinone, 2,3-dimethoxy-1,4-benzoquinone, or phenyl-1,4-benzoquinone, and diazophenylmethane; a compound with intramolecular polarization obtained by reacting any of the above tertiary phosphines, or phosphine compounds with a halogenated phenolic compound such as 4-bromophenol, 3-bromophenol, 2-bromophenol, 4-chlorophenol, 3-chlorophenol, 2-chlorophenol, 4-iodophenol, 3-iodophenol, 2-iodophenol, 4-bromo-2-methylphenol, 4-bromo-3-methylphenol, 4-bromo-2,6-dimethylphenol, 4-bromo-3,5-dimethylphenol, 4-bromo-2,6-di-*t*-butylphenol, 4-chloro-1-naphthol, 1-bromo-2-naphthol, 6-bromo-2-naphthol, or 4-bromo-4'-hydroxybiphenyl, and then performing a process of dehydrohalogenation; a tetra-substituted phosphonium such as tetraphenylphosphonium, and a tetra-substituted phosphonium and a tetra-substituted borate which have no phenyl group bonded to a boron atom, such as tetra-p-tolylborate; and a salt of a tetraphenyl phosphonium and a phenolic compound.

A content of a curing accelerator is preferably 1 part by mass or less, more preferably 0.5 parts by mass or less, and still preferably 0.3 parts by mass or less based on 100 parts by mass of the curable resin. In a case in which the content is 1 part by mass or less, the gelation time can be secured sufficiently, and the packing property can be excellent. A lower limit of the content of a curing accelerator is not particularly limited, and the curing accelerator may be contained.

### [Various Additives]

A curable resin composition may contain, in addition to the above-mentioned components, various additives, such as a coupling agent, a mold release agent, or a colorant, described below as examples. A curable resin composition may optionally contain various additives well known in the technical field in addition to the additives described below as examples.

### (Coupling Agent)

The curable resin composition may contain a coupling agent. By containing the coupling agent, adhesiveness between a resin constituent and the filler tends to enhance.

Examples of the coupling agent include known coupling agents, for example, silane compounds such as epoxysilane, (meth)acryloxysilane, mercaptosilane, aminosilane, alkylsilane, ureidosilane and vinylsilane, titanium compounds, aluminum chelate compounds, and aluminum- and zirconium-containing compounds. Among them, from the viewpoint of handling, a silane coupling agent is preferred. The coupling agent may be contained singly, or two or more kinds thereof may be contained in combination.

In a case in which the curable resin composition contains the coupling agent, an amount of the coupling agent is, based on 100 parts by mass of the filler, preferably from 0.05 parts by mass to 5 parts by mass, and more preferably from 0.1 parts by mass to 2.5 parts by mass.

### (Mold Release Agent)

The curable resin composition may contain a mold release agent. The mold release agent is not particularly limited, and examples thereof include mold release agents known in the art. Specific examples of the mold release agent include carnauba wax, higher fatty acids such as montanic acid and stearic acid, higher fatty acid metal salts, ester-based waxes such as montanic acid esters, and polyolefin-based waxes such as oxidized polyethylene and non-oxidized polyethylene. The mold release agent may be used singly, or in combination of two or more kinds thereof.

In a case in which the curable resin composition contains the mold release agent, an amount of the mold release agent is, based on 100 parts by mass of a total amount of the curable resin and the curing agent, preferably from 0.01 parts by mass to 10 parts by mass, and more preferably from 0.1 parts by mass to 5 parts by mass.

### (Colorant)

The curable resin composition may further contain a colorant. Examples of the colorant include known colorants such as carbon black, an organic dye, an organic pigment, titanium oxide, red lead, or red iron oxide. A content of the colorant may be preferably adjusted depending on purpose. The colorant may be used singly, or in combination of two or more kinds thereof.

In a case in which the curable resin composition contains the colorant, an amount of the colorant is, based on 100 parts by mass of a total amount of the curable resin and the curing agent, preferably from 0.01 parts by mass to 10 parts by mass, and more preferably from 0.1 parts by mass to 5 parts by mass.

### (Properties and Preparation of Curable Resin Composition)

A curable resin composition in the present disclosures is solid at 25°C (room temperature) under normal pressure.

Further, a curable resin composition in the present disclosures has a gelation time at 110°C of 10 min or more. The gelation time at 110°C is preferably 30 min or more, and more preferably 60 min or more. Since the suitable gelation time at 110°C varies depending on the production process, it is preferable to select it appropriately. Therefore, the preferable gelation time at 110°C is not limited to the above range insofar as it is 10 min or longer.

The gelation time at 110°C is measured according to JIS K 6300-2: 2001. Specifically, torsional oscillations are applied at 110°C under a constant pressure, and the force (torque) received via the curable resin composition is measured. The temperature at which the torque clearly starts increasing is measured as the gelation time.

A curable resin composition in the present disclosures preferably has a gelation time at 175°C of 2 hours or less, more preferably 1 hour or less, and further preferably 25 min or less. In a case in which the gelation time at 175°C is 2 hours or less, the curing time can be short, and the manufacturing time of a semiconductor device tends to be shortened.

The gelation time at 175°C is measured according to JIS K6300-2: 2001, identically with the method of measuring the gelation time at 110°C except that the temperature is changed to 175°C.

A curable resin composition in the present disclosures preferably has a viscosity at 110°C of 1000 Pa s or less, and more preferably 50 Pa s or less. In a case in which the viscosity at 110°C is 1000 Pa·s or less, the moldability tends to become better.

The viscosity at 110°C is measured using a rheometer (cone diameter 25 mm, frequency 1 Hz). As the rheometer, for example, "AR2000" (trade name, manufactured by TA Instruments) may be used.

With respect to a cured product of a curable resin composition in the present disclosures , a ratio of a glass transition temperature (Tg) after an elapse of 1000 hours at 215°C and that before the lapse of time (Tg after the lapse of time/Tg at initial stage) is preferably 0.9 or more. In a case in which the ratio of "Tg after the lapse of time/Tg at initial stage" is 0.9 or more, the high temperature stability is excellent, which is more suitable in sealing a power module generating a large amount of heat.

A glass transition temperature (Tg) can be determined by the TMA method.

With respect to a cured product of a curable resin composition in the present disclosures , the average coefficient of thermal expansion in a range of from 30°C to 250°C is preferably 50 ppm/K or less, and more preferably 40 ppm/K or less. In a case in which the average coefficient of thermal expansion in a range of from 30°C to 250°C is 50 ppm/K or less, the difference in the coefficient of thermal expansion with a semiconductor chip becomes small, so that warping due to heat tends to be suppressed.

An average coefficient of thermal expansion can be measured as follows.

A cured product with a size of 3 mm × 3 mm × 10 mm is prepared, which temperature is raised from 30°C to 260°C at a rate of 5°C/min using a thermomechanical analyzer (for example, "TMA2940" from TA Instruments).

A curable resin composition in the present disclosures in a form of a cured product has a modulus of elasticity at 25°C of preferably from 5 GPa to 25 GPa, and more preferably from 10 GPa to 20 GPa. In a case in which the modulus of elasticity at 25°C is 5 GPa or more, a stress to be generated due to the difference in coefficient of thermal expansion with another member in the power module tends to be effectively suppressed. In a case in which the modulus of elasticity at 25°C is 25 GPa or less, a stress to be generated due to the cured product itself of the curable resin composition tends to be effectively suppressed.

A modulus of elasticity at 25°C can be measured by the following method.

A cured product with a size of 10 mm × 50 mm × 3 mm is prepared, which temperature is raised from 25°C to 300°C at a rate of 10°C/min using a thermomechanical analyzer (for example, "RSAIII" from TA Instruments), and the modulus of elasticity (GPa) at 25°C is determined.

For preparing a curable resin composition, a method heretofore publicly known may be appropriately used, and a kneader, a planetary mixer, a three-roll mill, a twin-screw extruder or the like may be favorably used.

### <Semiconductor Device>

A semiconductor device in the present disclosures includes a semiconductor element, and a cured product of a curable resin composition in the present disclosures for sealing the semiconductor element. If necessary, it may include another component. A curable resin composition in the present disclosures may be suitably used for a power module application to be exposed to a harsh operating environment, from the viewpoint of heat resistance, electrical insulation and the like.

### <Method of producing Semiconductor Device>

A method of producing a semiconductor device in the present disclosures, for example, includes: accommodating a semiconductor element in a non-pressurized type case; filling the non-pressurized type case with the curable resin composition in the present disclosures by putting the curable resin composition in a solid state into the non-pressurized type case and then heating to melt the curable resin composition, or heating to melt the curable resin composition and then pouring the curable resin composition into the non-pressurized type case; and curing the curable resin composition in the non-pressurized type case.

The heating temperature for melting a curable resin composition may be appropriately set according to the kind of curable resin used. For example, in a case in which an epoxy resin is used as a curable resin, the temperature may be set in a range of from 90°C to 140°C.

There is no particular restriction on the curing conditions for a curable resin composition, and, for example, it may be cured at a temperature in a range of from 170 °C to 180°C for time duration of from 3 hours to 24 hours.

### EXAMPLES

The present embodiment will be specifically described below with reference to Examples. However, the present embodiment is not limited to these Examples.

### (Preparation of Curable Resin Composition)

The components listed in Table 1 were mixed in the amounts (parts by mass) set forth in Table 1, kneaded in a twin-screw extruder whose internal temperature was adjusted in a range of from 70°C to 100°C, and after cooling pulverized to prepare a curable resin composition. In this regard, the value in parentheses in the row of filler stands for the volume-based content of the filler (% by volume) in the curable resin composition. The details of each component are as follows.
- Epoxy resin: Multifunctional epoxy resin having an epoxy equivalent of from 163 g/eq to 175 g/eq, and a softening point of from 57°C to 63°C
- Curing agent: Phenol novolak resin having a hydroxyl equivalent of 106 g/eq, and a softening point of from 68°C to 74°C
- Curing accelerator: 2-Phenylimidazole
- Coupling agent: 3-Methacryloxypropyltrimethoxysilane
- Mold release agent: Montanic acid ester
- Colorant: Carbon black
- Filler: Fused silica particles with D50 of 19.9 µm (catalog value)

### (Measurement of Viscosity)

A prepared curable resin composition was heated to 110°C, and the viscosity was measured using a rheometer (cone diameter 25 mm, frequency 1 Hz).

### (Measurement of Gelation Time)

At a constant temperature (110°C or 175°C), torsional oscillations were applied under a constant pressure, and the force (torque) received via the curable resin composition was measured. In doing so the temperature at which the torque clearly started increasing was measured as the gelation time.

The results are shown in Table 2.

### (Evaluation of Moldability)

A prepared curable resin composition was heated to 130°C and the melted curable resin composition was poured into a case mold (upward opened) having a size of 15 cm × 15 cm × 0.3 cm, and then cooled.

The obtained molded product was inspected in terms of surface smoothness, presence or absence of air bubbles and cracks, and that without any abnormalities was designated as "OK", and that with abnormalities was designated as "NG".

### (Preparation of Cured Product)

A curable resin composition which was poured into a case mold (upward opened) having a size of 15 cm × 15 cm × 0.3 cm, and cooled, was kept in a high temperature bath at 175°C for 6 hours to obtain a cured product.

### (Measurement of Glass Transition Temperature)

The glass transition temperature (Tg) of the obtained cured product was measured by the TMA method.

### (Evaluation of Average Coefficient of Thermal Expansion)

The average coefficient of thermal expansion of a cured product having a size of 3 mm × 3 mm × 10 mm was measured using a "TMA2940" from TA Instruments. The measurement was performed in a range of from 30°C to 260°C at a rate of temperature increase of 5°C/min. The results are shown in Table 1.

### (Evaluation of Modulus of Elasticity)

A cured product with a size of 10 mm × 50 mm × 3 mm was prepared, which temperature was raised from 25°C to 300°C at a rate of 10°C/min using a thermomechanical analyzer ("RSAIII" from TA Instruments), and the modulus of elasticity (GPa) was determined.

### (Evaluation of Flame Retardancy)

The flame retardancy was evaluated according to the UL94 standard, by which a cured product having a size of 12.5 mm wide, 100 mm long, and 6.4 mm thick was fixed vertically, a burner flame was placed under the specimen for 10 sec, then the flame was removed. The combustion extinction time after removing the flame was measured, and in a case where the combustion extinction time was 10 sec or less, it was rated as "V-O". In a case where the combustion extinction time was beyond 10 sec, it was rated as "Combustible". The results are shown in Table 1.

### (Evaluation of High Temperature Stability)

On a cured product having a size of 3 mm × 3 mm × 10 mm, the glass transition temperature (Tg) was measured before and after an elapse of 1000 hours at 215°C and the ratio thereof (Tg after the lapse of time/Tg at initial stage) was calculated. The results are shown in Table 1.

**[Table 1]**

| | | Example 1 | Example 2 |
|---|---|---|---|
| Epoxy Resin | | 100 | 100 |
| Curing Agent | | 62.7 | 62.8 |
| Curing Accelerator | | 0.1 | 0.03 |
| Coupling Agent | | 3 | 3 |
| Mold Release Agent | | 1.5 | 1.5 |
| Colorant | | 2.6 | 2.6 |
| Filler | | 534 (62) | 534 (62) |
| State at 25°C (Room temperature) | | Solid | Solid |
| Viscosity at 110°C (Pa·s) | | 45 | 30 |
| Moldability | | OK | OK |
| Gelation Time | 110°C | 200 min | >240 min |
| | 175°C | 8 min | 19 min |
| Tg (°C) | | 172 | 175 |
| Average Coefficient of Thermal Expansion (ppm/K) | | 29 | 29 |
| Modulus of Elasticity | | 15 | 15 |
| Flame Retardancy | | V-0 | V-0 |
| High Temperature Stability | | 1.1 | 1.1 |

As shown in Table 1, when a curable resin composition which had a gelation time at 110°C of 10 min or more, and which was solid at 25°C was used, the moldability was excellent. When such a curable resin composition was used, the high temperature stability was also excellent, and the coefficient of thermal expansion was kept low.

Next, as comparative examples, the same evaluations as above were carried out using a liquid epoxy resin composition 1 (using an amine as the curing agent), a liquid epoxy resin composition 2 (using an acid anhydride as the curing agent), a 1-component type silicone gel (Product name "SE1880GEL" produced by Toray Industries, Inc.), and 2-component type silicone gel (Product name "SE1886AGE" produced by Toray Industries, Inc.).

**[Table 2]**

| | Comparative Example 1 | Comparative Example 2 | Comparative Example 3 | Comparative Example 4 |
|---|---|---|---|---|
| | Liquid Epoxy 1 (Amine type) | Liquid Epoxy 2 (Acid anhydride type) | Silicone Gel (1-component type) | Silicone Gel (2-component type) |
| State at 25°C (Room temperature) | Liquid | Liquid | Liquid | Liquid |
| Moldability | OK | OK | OK | OK |
| Tg (°C) | 200 | 180 | - | - |
| Average Coefficient of Thermal Expansion (ppm/K) | 13 | 15 | 300 | 300 |
| Flame Retardancy | Combustible | Combustible | V-0 | V-0 |
| High Temperature Stability | 0.8 | 0.8 | - | - |

As shown in Table 2, the silicone gels exhibited an extremely high coefficient of thermal expansion. Further, the liquid epoxy resin compositions were inferior in high temperature stability.

The disclosures of Japanese Patent Application No. 2018-005175 is incorporated herein by reference in their entirety.

All documents, patent applications, and technical standards described in the present specification are incorporated herein by reference to the same extent as if each individual document, patent application, or technical standard were specifically and individually indicated to be incorporated by reference.

## Claims

1. A curable resin composition for non-pressurized type case mold sealing, which is solid at 25°C and which has a gelation time at 110°C of 10 min or more.

2. The curable resin composition for non-pressurized type case mold sealing according to claim 1, wherein the curable resin composition has a viscosity at 110°C of 1000 Pa·s or less.

3. The curable resin composition for non-pressurized type case mold sealing according to claim 1 or 2, wherein the curable resin composition has a gelation time at 175°C of 2 hours or less.

4. The curable resin composition for non-pressurized type case mold sealing according to any one of claims 1 to 3, wherein a ratio of a glass transition temperature (Tg) after an elapse of 1000 hours at 215°C and that before the lapse of time (Tg after the lapse of time/Tg at initial stage) is 0.9 or more in a case in which the curable resin composition is cured.

5. The curable resin composition for non-pressurized type case mold sealing according to any one of claims 1 to 4, wherein an average coefficient of thermal expansion in a range of from 30°C to 250°C, is 50 ppm/K or less in a case in which the curable resin composition is cured.

6. The curable resin composition for non-pressurized type case mold sealing according to any one of claims 1 to 5, wherein a modulus of elasticity at 25°C is from 5 GPa to 25 GPa in a case in which the curable resin composition is cured.

7. A semiconductor device comprising:
a semiconductor element, and
a cured product of the curable resin composition according to any one of claims 1 to 6, which seals the semiconductor element.

8. A method of producing a semiconductor device comprising:
accommodating a semiconductor element in a non-pressurized type case,
filling the non-pressurized type case with the curable resin composition according to any one of claims 1 to 7 by putting the curable resin composition in a solid state into the non-pressurized type case and then heating to melt the curable resin composition, or heating to melt the curable resin composition and then pouring the curable resin composition into the non-pressurized type case, and
curing the curable resin composition in the non-pressurized type case.
